# EUROPEAN PATENT APPLICATION

(11) **EP 1 274 123 A1**
(43) Date of publication of application: **08.01.2003**
(21) Application number: 01921818.9
(22) Date of filing: 12.04.2001
(51) Int. Cl.: H01L 21/304

(54) **POLISHING COMPOUND FOR POLISHING SEMICONDUCTOR DEVICE AND METHOD FOR MANUFACTURING SEMICONDUCTOR DEVICE USING THE SAME**

(30) Priority: 13.04.2000 JP 2000112532
(71) Applicant: SHOWA DENKO K.K., Tokyo 105-8518 (JP)
(72) Inventor: KIDO, Takanori, Showa Denko K.K. Shiojiri Plant, Shiojiri-shi, Nagano 399-6461 (JP); TSUJINO, Fumio, Showa Denko K.K. Shiojiri Plant, Shiojiri-shi, Nagano 399-6461 (JP)
(74) Representative: Smith, Norman Ian
(86) International application number: JP0103147
(87) International publication number: WO01080296

(57) **Abstract**

An abrasive composition for polishing a semiconductor device includes water, microparticles of an abrasive and a chelating agent. The abrasive microparticles are cerium oxide microparticles having an average particle size of 0.01-1.0 µm. A selectivity ratio of the rate of polishing a silicon nitride film to the rate of polishing a silicon oxide film is 10 or more. For these reasons, the planarization-polishing step can be performed with high controllability. In addition, scratches being formed on the polished surface can be reduced to a great extent, and the still remaining abrasive particles can readily be removed from the polished wafer through washing. Therefore, the abrasive composition is advantageously used as that for polishing the oxide film to form a semiconductor device having a shallow trench isolation structure in a well-controlled manner.

## Description

### Technical Field:

The present invention relates to an abrasive composition generally employed for polishing a semiconductor device and to a method for producing a semiconductor device using the composition.

### Background Art:

Recently, as a method for isolating elements in a semiconductor device, a shallow trench isolation method that enables production of semiconductor devices of high package density has become of interest. This method is a technique employed instead of a conventional local oxidation of silicon (LOCOS). Specifically, trench isolation is a method of interest in which a silicon nitride film is formed on a silicon substrate, a shallow trench is formed, an oxide film is formed on the silicon nitride film, and the surface is planarized through CMP with the silicon nitride film used as a stopper. The trench isolation method, being capable of advantageously providing a wide effective element area, is quite a promising technique for producing LSIs of high package density.

When LSIs of high package density are produced through this method in which a silicon nitride film is provided underneath an oxide film to be polished, and polishing is effected with the silicon nitride film used as a stopper, a uniform device surface can be obtained by evenly polishing off the removal amount of the surface to be planarized. Polishing can be terminated in a well-controlled manner at a point at which a predetermined removal amount has reached.

Regarding abrasive compositions suitable for such a method, JP-A HEI 9-194823 discloses an abrasive composition containing abrasive particles such as of silicon nitride, silicon carbide, graphite, etc. and JP-A HEI 9-208933 discloses an abrasive composition containing silicon nitride powder and an acid such as gluconic acid.

Although these abrasive compositions provide a high polishing rate due to high-hardness abrasives incorporated therein, many scratches are formed on the polished surface by the abrasives, thereby causing problems such as deterioration of the performance of LSIs.

In addition, since the polishing index of oxide film (silicon dioxide film is typically used) with respect to silicon nitride film serving as a stopper (typically, the index is represented by "selectivity" that is the rate of polishing an oxide film divided by the rate of polishing a silicon nitride film) attained through a conventional technique is unsatisfactory, there is a demand for further elevating the index.

In view of the foregoing, the present inventors previously disclosed, in International Patent Publication WO 99/43761, an abrasive composition for polishing a semiconductor device comprising water, cerium oxide and a water-soluble organic compound having at least one functional group selected from among -COOH, -COOMₓ groups (Mₓ represents an atom or a functional group capable of forming a salt through substitution by an H atom), -SO₃H and -SO₃M_{Y} groups (M_{Y} represents an atom or a functional group capable of forming a salt through substitution by an H atom), with an optional chelating agent added thereto when necessary. The inventors also proposed a method for forming an element through shallow trench isolation by use of the abrasive composition.

When such an abrasive composition as disclosed in the above patent publication is used, a high "selectivity" can be attained and scratches on the wafer surface can be advantageously reduced. However, washing performance of the polished wafer surface is unsatisfactory.

US Patent No. 5,738,800 discloses a composition containing water, abrasive particles, a surfactant, and a compound which can form a complex with silicon oxide or silicon nitride, and a method for forming a shallow trench isolation structure by use of the composition. This patent clearly specifies that a high "selectivity" can be attained only when the surfactant is added and that addition of the surfactant is essential. Specifically, the employed abrasive composition contains a fluorine-containing surfactant in an amount of approximately 0.1-0.5%. However, since most surfactants exhibit a strong surface activation effect and foam-generating property, an abrasive composition containing such a surfactant is not always suited for polishing a semiconductor device.

JP-A HEI 10-163140 discloses a polishing method for planarizing the semiconductor device surface including a principal polishing step making use of polishing liquid and a finish-polishing step making use of a chelating agent. However, the two-step polishing method attains low efficiency, leading to a problematic low production yield.

JP-A HEI 7-70553 discloses a polishing liquid for polishing an aluminum-containing substrate, which contains a chelating agent that can form a complex in conjunction with aluminum. However, since the technique disclosed in that publication is intended for application to polishing a glass substrate or a similar substrate, the performance required of the composition is completely different from that required for forming a shallow trench isolation structure according to the present invention.

As described above, in order to form a shallow trench isolation structure, there is a strong demand for an abrasive composition that attains a high "selectivity," provides few scratches on the polished surface and readily removes abrasive particles through washing.

An object of the present invention is to provide an abrasive composition for polishing a semiconductor device, that can attain a selectivity of 10 or more and is usable advantageously for forming a shallow trench isolation structure with high controllability and excellent in removability of abrasive particles from a polished wafer through washing, thereby solving the aforementioned drawbacks and problems.

Another object of the present invention is to provide a method for producing a semiconductor device, which can realize high productivity and prevent a decrease in performance and yield and in which there is used, in a shallow trench isolation using the nitride film as a stopper, an abrasive composition that exhibits a high rate of polishing an oxide film and a high ratio of a rate of polishing a nitride film to the rate of polishing the oxide film and provides few scratches on a polished surface that cause poor performance of an LSI and few abrasive particles remaining on the polished surface after washing.

### Disclosure of the Invention:

The present invention provides an abrasive composition for polishing a semiconductor device, comprising water, microparticles of an abrasive and a chelating agent, wherein the abrasive is cerium oxide, the microparticles of cerium oxide have an average particle size of 0.01-1.0 µm, and, when silicon nitride film and silicon oxide film separately formed on a silicon substrate through CVD, are polished independently under identical conditions, a ratio of a rate of polishing the silicon nitride film to a rate of polishing the silicon oxide film is 10 or more.

In the abrasive composition, the abrasive further includes additional microparticles for polishing. The additional microparticles are formed of at least one species selected from the group consisting of aluminum oxide, zirconium oxide, silicon dioxide, titanium dioxide, manganese dioxide, dimanganese trioxide, chromium oxide, iron oxide, tin oxide, zinc oxide, alumina-magnesia spinel, mullite, zircon, aluminum hydroxide, calcium hydroxide, magnesium hydroxide, silicon nitride, titanium nitride, boron nitride, silicon carbide, titanium carbide and diamond.

In the abrasive composition, the cerium oxide has a concentration of 0.1-10 mass% and the chelating agent is added at a mass ratio of 0.01-10 based on the mass of the cerium oxide.

In the abrasive composition, the cerium oxide microparticles and additional microparticles have a total concentration of 0.1-10 mass% and the chelating agent is added at a mass ratio of 0.01-10 based on the mass of all microparticles.

In the abrasive composition, the chelating agent is at least one compound selected from the group consisting of ethylenediaminetetraacetic acid (EDTA), cyclohexanediaminetetraacetic acid (CyDTA), nitrilo-triacetic acid (NTA), hydroxyethylethylenediaminetriacetic acid (HEDTA), diethylenetriaminepentaacetic acid (DTPA), triethylenetetraminehexaacetic acid (TTHA), L-glutamine-diacetic acid (GLDA), aminotri(methylenephosphonic acid), 1-hydroxyethylidene-1,1-diphosphonic acid, ethylenediamine-tetra (methylenephosphonic acid), diethylenetriamine-penta (methylenephosphonic acid), β-alaninediacetic acid (β-ADA), α-alaninediacetic acid (α-ADA), asparaginediacetic acid (ASDA), ethylenediaminesuccinic acid (EDDS), iminodiacetic acid (IDA), hydroxyethyliminodiacetic acid (HEIDA) and 1,3-propanediaminetetraacetic acid (1,3-PDTA), or a salt thereof.

The abrasive composition may further comprise a dispersant having a concentration of 0.08 mass% or less. The dispersant contains a poly(acrylic acid) moiety or a poly(methacrylic acid) moiety.

The abrasive composition excluding the abrasive microparticles contains, as an impurity, at least one element selected from the group consisting of Mg, Al, K, Ca, Fe, Ni, Cu, Mn, Th and U at a concentration of 20 ppm or less.

In the abrasive composition, the cerium oxide microparticles have a purity of 99.9 mass% or more and contain, as an impurity, at least one element selected from the group consisting of Mg, Al, K, Ca, Fe, Ni, Cu, Mn, Th and U at a concentration of 30 ppm or less.

The present invention further provides a method for producing a semiconductor device, comprising forming a silicon nitride film on a semiconductor substrate, selectively removing part of the silicon nitride film to thereby expose part of the semiconductor substrate, etching the exposed part of the semiconductor substrate with the silicon nitride film used as a mask to thereby form a trench, depositing a silicon oxide film on the silicon nitride film and on the exposed part of the semiconductor substrate to thereby completely bury the trench with the silicon oxide film, and planarization-polishing the silicon oxide film with the silicon nitride film used as a stopper to thereby selectively leave the silicon oxide remaining in the trench, wherein planarization-polishing is performed using the abrasive composition.

The present invention further provides a semiconductor substrate having an element-isolated structure produced through the method.

When the abrasive composition is used, since the rate of polishing the oxide film is high and the selectivity of the nitride film with respect to the oxide film is large, the planarization-polishing step can be performed with high controllability. Furthermore, scratches being formed on the polished surface can be reduced to a great extent, and the still remaining abrasive particles can readily be removed from the polished wafer through washing. Therefore, the abrasive composition is advantageously used as that for polishing the oxide film to form a semiconductor device having a shallow trench isolation structure in a well-controlled manner.

### Brief Description of the Drawings:

Figure 1 is a cross-sectional view showing a semiconductor substrate, wherein a shallow trench has been formed on the surface of the semiconductor substrate coated with a silicon oxide film and a silicon nitride film.
Figure 2 is a cross-sectional view showing the semiconductor substrate, wherein the shallow trench shown in Figure 1 is filled with a silicon oxide film.
Figure 3 is a cross section showing the semiconductor substrate, wherein the silicon oxide film shown in Figure 2 has been planarized to form a shallow trench isolation structure.
Figure 4 is a cross section showing the semiconductor substrate, wherein the coated silicon nitride film and silicon oxide film have been removed from the shallow trench isolation structure shown in Figure 3.

### Best Mode for Carrying Out the Invention:

The abrasive composition of the present invention for polishing a semiconductor device will now be described.

When an element-isolated structure is formed through the shallow trench isolation method, the surface of a substrate having an element-isolated structure (e.g., broadly referred to as a semiconductor device) must be planarized. In order to meet this requirement, the present invention provides an abrasive composition for polishing a semiconductor device, which composition can effectively be used for forming such an element-isolated structure.

The abrasive composition of the present invention comprises water, microparticles of cerium oxide and a chelating agent.

The cerium oxide used in the abrasive composition of the present invention preferably has high purity. For example, the purity is 99 mass% or higher, more preferably 99.5 mass% or higher, particularly preferably 99.9 mass% or higher. When the purity is low, impurity elements detrimental to semiconductor characteristics are difficult to remove from the surface of a semiconductor device, even though the polished semiconductor device is washed. Thus, the number of defective products increases, resulting in an undesired low production yield.

When cerium oxide is of high-purity (e.g., 99.9 mass% or higher as mentioned above) (see Example 1), the cerium oxide microparticles contain Mg, Al, K, Ca, Fe, Ni, Cu, U, Th and Mn at a concentration, for each element, as low as 30 ppm or less, preferably 10 ppm or less, more preferably 3 ppm or less. When the concentration of any of these elements is in excess of 30 ppm, the number of defective products increases as described above, resulting in an undesirably low production yield.

When cerium oxide is used as abrasive microparticles for preparing the abrasive composition for polishing a semiconductor device, which composition comprises water, abrasive microparticles and a chelating agent, there can be provided an abrasive composition for polishing a semiconductor device which composition may contain, in addition to the abrasive microparticles, at least one impurity element selected from the group consisting of Mg, Al, K, Ca, Fe, Ni, Cu, Mn, Th and U at a concentration as low as 20 ppm or less, preferably 10 ppm or less, more preferably 1 ppm or less.

The cerium oxide microparticles preferably have an average particle size (d₅₀) of 0.01 µm to 1.0 µm, more preferably 0.1 µm to 0.5 µm. When cerium oxide microparticles having a d₅₀ of less than 0.01 µm are used, the rate of polishing an oxide film (usually silicon dioxide film) formed on a semiconductor device decreases, whereas when the d₅₀ is in excess of 1.0 µm, the polished surface readily receives micro-scratches. Both cases are disadvantageous. The average particle size (d₅₀) as used herein is preferably measured through a dynamic light scattering method.

The cerium oxide microparticles preferably have a primary particle size of 0.005 µm to 0.5 µm, more preferably 0.02 µm to 0.2 µm. When the primary particle size is less than 0.005 µm, the rate of polishing the oxide film considerably decreases, failing to attain a high selectivity, whereas when the primary particle size is in excess of 0.5 µm, the polished surface readily receives micro-scratches. Both cases are disadvantageous. The primary particle size as used herein is preferably a value calculated from the specific surface area determined through the BET method, assuming that the particles are spherical.

The cerium oxide (microparticles) concentration in the abrasive composition of the present invention varies depending on the polishing conditions, such as process pressure during polishing. However, the concentration is preferably 0.1-10 mass%, more preferably 0.3-5 mass%. When the concentration is less than 0.1 mass%, the rate of polishing an oxide film decreases, whereas when the concentration is in excess of 10 mass%, the effect commensurate with an increase in amount of the cerium oxide, i.e. an increase in rate of polishing the oxide film, cannot be attained. This case is undesirable in terms of cost. The cerium oxide concentration as defined herein refers to the cerium oxide concentration in the abrasive composition during use.

The chelating agent used in the abrasive composition of the present invention will next be described.

The chelating agent may be a known chelating agent, with no particular limitations placed on the chemical structure thereof. However, specific examples of preferred chelating agents according to the present invention include ethylenediaminetetraacetic acid (EDTA), cyclohexanediaminetetraacetic acid (CyDTA), nitrilotriacetic acid (NTA), hydroxyethylethylenediaminetriacetic acid (HEDTA), diethylenetriaminepentaacetic acid (DTPA), triethylenetetraminehexaacetic acid (TTHA), L-glutaminediacetic acid (GLDA), aminotri(methylenephosphonic acid), 1-hydroxyethylidene-1,1-diphosphonic acid, ethylenediaminetetra (methylenephosphonic acid), diethylenetriaminepenta (methylenephosphonic acid), β-alaninediacetic acid (β-ADA), α-alaninediacetic acid ( α-ADA), asparaginediacetic acid (ASDA), ethylenediaminesuccinic acid (EDDS), iminodiacetic acid (IDA), hydroxyethyliminodiacetic acid (HEIDA) and 1,3-propanediaminetetraacetic acid (1,3-PDTA).

Of these examples, ethylenediaminetetraacetic acid (EDTA), nitrilotriacetic acid (NTA), β-alaninediacetic acid (β-ADA), α-alaninediacetic acid (α-ADA), asparaginediacetic acid (ASDA), ethylenediaminesuccinic acid (EDDS) and hydroxyethyliminodiacetic acid (HEIDA) are preferable.

Generally, the chelating agent is used in the form of a free acid or a salt. However, addition of the free acid at a high concentration is limited, due to poor solubility thereof in water. Thus, the chelating agent is preferably used in the form of a salt. Although no particular limitation is imposed on the salt species in the present invention, a quaternary ammonium salt is preferably used in the case in which the characteristics of LSIs are possibly affected adversely.

Specific examples of preferred salts include lithium salts, sodium salts, potassium salts and cesium salts. Examples of preferred amines that can form the aforementioned quaternary ammonium salt include ammonia; primary, secondary and tertiary amines having a C1-C10, linear or branched, saturated or unsaturated alkyl group; primary, secondary and tertiary amines having at least one C6-C10 aromatic group; and cyclic amines such as piperidine and piperazine.

The amount of the chelating agent to be added varies depending on the cerium oxide microparticle concentration in the composition of the present invention, on the pH of the composition and on polishing conditions such as process pressure during polishing. However, typically, the mass ratio of the chelating agent to cerium oxide is preferably 0.01-10, more preferably 0.05-5, further preferably 0.1-3. When the mass ratio is less than 0.01, the amount of the chelating agent adsorbed onto the silicon nitride film surface is small relative to the amounts of abrasive particles which act during polishing, forming a poor adsorption layer and attaining a poor effect of preventing direct contact between the cerium oxide microparticles and the silicon nitride film. Thus, the rate of polishing the silicon nitride film cannot be reduced. In contrast, when the mass ratio is in excess of 10, an effect fails to be commensurate with an increase in amount of the chelating agent, leading to a cost disadvantage.

Furthermore, the abrasive composition of the present invention may contain an additional abrasive in combination with cerium oxide. In this case, the amount of the additional abrasive is 0.01-50 mass%, preferably 0.1-20 mass%, more preferably 0.5-10 mass%, based on the total amount of the abrasives. Preferably, the total microparticle concentration of cerium oxide and the additional abrasive is 0.1-10 mass% based on the mass of the composition, and the amount of a chelating agent added is 0.01-10 times the total mass of the microparticles. The average particle size of the additional abrasive other than cerium oxide is preferably 0.01-1.0 µm, more preferably 0.1 µm to 0.5 µm.

Preferably, the additional abrasive is arbitrarily selected from among compounds, such as aluminum oxide, zirconium oxide, silicon dioxide, titanium dioxide, manganese dioxide, dimanganese trioxide, chromium oxide, iron oxide, tin oxide, zinc oxide, alumina-magnesia spinel, mullite, zircon, aluminum hydroxide, calcium hydroxide, magnesium hydroxide, silicon nitride, titanium nitride, boron nitride, silicon carbide, titanium carbide and diamond. Of these compounds, aluminum oxide, zirconium oxide, silicon dioxide and titanium dioxide are advantageously usable in particular.

The aforementioned abrasive composition according to the present invention may further contain a dispersant. In this case, an abrasive composition for polishing a semiconductor device, in which the dispersant content is adjusted to 0.08 mass% or less, is preferred. Known dispersants may be employed as the aforementioned dispersant. Of these, a poly(organic carboxylic acid) is preferred. Examples of such dispersants include a dispersing agent0 having a poly(acrylic acid) moiety or a poly(methacrylic acid) moiety. The abrasive composition of the present invention may employ the poly(organic carboxylic acid) in the form of an ammonium salt or a quaternary ammonium salt of other organic amines.

The abrasive composition of the present invention provides high selectivity of the rate of polishing a silicon oxide film to that of polishing a silicon nitride film. The selectivity can be adjusted to 10 or higher, more preferably 30 or higher, particularly preferably 50 or higher. In addition, use of the abrasive composition of the present invention drastically reduces scratching on the polished surface and enhances washout efficiency of the abrasive particles remaining on the polished wafer.

The method for forming a shallow trench isolation structure in a semiconductor device by use of the abrasive composition will next be described.

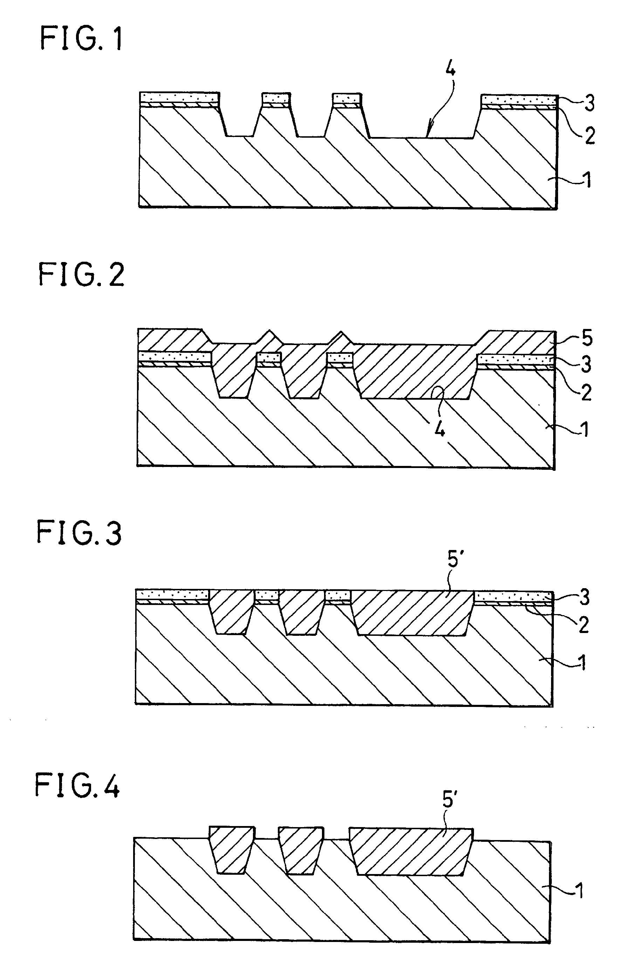

The method is described with reference to the drawings. As shown in Figure 1, the surface of a semiconductor substrate 1 made of a substance, such as silicon, is slightly oxidized to thereby form a silicon oxide film 2 and subsequently, a silicon nitride film 3 having a thickness of 200 nm, for example, is deposited thereon through a technique such as CVD. Next, a recess having a width of 500-5000 nm, for example, is formed in a predetermined position of the silicon nitride film 3 where a shallow trench is to be formed, through a technique such as photolithography making use of a photoresist.

Subsequently, the semiconductor substrate 1 is selectively etched, with the silicon nitride film 3 having a recess therein utilized as a mask, to thereby form a shallow trench 4 having a depth of 500 nm, for example.

On the entire surface of the semiconductor substrate 1 coated with the silicon nitride film 3, a silicon oxide film 5 is deposited through a technique, such as bias CVD that is a technique for attaining a good burying property, to thereby completely bury the trench 4 with the silicon oxide film 5 (see Figure 2).

The thus-obtained surface of the silicon oxide film 5 has a recess on the buried trench 4. However, by planarization-polishing the surface making use of the abrasive composition, the surface is gradually polished to thereby yield a planar surface. As the polishing proceeds, the surface of the silicon oxide film becomes completely planar to thereby remove the recess from the trench 4 until the polished surface reaches the surface of the silicon nitride film 3. the polishing is terminated when the surface of the silicon nitride film 3 is exposed. Thus, a trench 5' for shallow trench isolation is formed as shown in Figure 3. Although the silicon nitride film 3 may serve as an insulating film formed on the semiconductor, the film is typically removed as shown in Figure 4.

In the aforementioned planarization polishing for forming a shallow trench isolation structure, a high ratio of the rate of polishing the silicon oxide to that of polishing the silicon nitride, i.e. a high selectivity, is required in order to effectively polish the silicon oxide film and to accurately terminate the polishing when the polished surface coincides with the level of the silicon nitride film. In addition, when the planarization-polished surface is scratched, LSI characteristics may disadvantageously be impaired.

The abrasive composition of the present invention has been developed in order to provide an abrasive composition optimal for carrying out the aforementioned planarization polishing. Use of the abrasive composition of the present invention can achieve a selectivity of 10 or higher, preferably 30 or higher, more preferably 50 or higher that varies depending on the size and amount of the abrasive particles and on the kind and amount of the chelating agent, attaining highly controllable planarization polishing. In addition, another advantage lies in that scratches on the polished surface can be removed and that the abrasive particles remaining on the polished wafer can effectively be removed by washing.

Polishing by use of the abrasive composition of the present invention can be performed through a known polishing method or a chemical mechanical polishing (CMP) method.

The present invention will next be described in more detail giving examples, which should not be construed as limiting the invention thereto.

### Example 1:

Cerium oxide of high purity was prepared from a commercially available cerium carbonate through heat treatment. The thus prepared cerium oxide had an average particle size (d₅₀) of 0.2 µm, a primary particle size of 0.08 µm and a purity of 99.9 mass% or higher (chemical analysis data: concentration of each of elements Mg, Al, K, Ca, Fe, Ni, Cu, Mn, Th and U = 3 ppm or less). Subsequently, 1 mass% of the prepared cerium oxide microparticles, 0.3 mass% of triammonium ethylenediamine tetraacetate (EDTA·H·3(NH₄)) and the balance of water were mixed to thereby prepare an abrasive composition in slurry form. In the composition, the EDTA·H·3(NH₄) was incorporated so that the ratio by mass of the EDTA·H·3(NH₄) to cerium oxide was controlled to 0.3. The pH of the composition was 7.2. After removal of the abrasive microparticles from the slurry was complete, the remaining aqueous solution was analyzed, and the concentration of each of the impurity elements Mg, Al, K, Ca, Fe, Ni, Cu, Mn, Th and U was found to be 0.5 ppm or less.

Subsequently, the abrasive slurry was evaluated in terms of polishing performance on the silicon dioxide film and silicon nitride film, in the following manner.

### [Polishing Conditions]

Material to be polished: (1) Silicon dioxide film (film thickness: approximately 1 µm) formed through CVD on a silicon wafer having a diameter of 6 inches and a thickness of 625 µm, and (2) silicon nitride film (film thickness: approximately 0.5 µm) formed through CVD on a silicon wafer having a diameter of 6 inches and a thickness of 625 µm.
Pad: Double-layer-type polishing pad for polishing a semiconductor device (IC1000/Suba400 produced by Rodel-Nitta K.K.).
Polishing apparatus: One-side polishing machine for polishing a semiconductor device (Model SH-24 with a surface plate diameter of 610 mm, produced by SpeedFam Co., Ltd.).
Rotation rate of surface plate: 70 rpm.
Process pressure: 300 gf/cm².
Slurry feed rate: 100 ml/min.
Polishing time: 1 min.

### [Items and method of evaluation]

Polishing rate: Measured by an optical-interference-type film-thickness measurement apparatus.

Scratch status: Dark-field observation under an optical microscope.
(Three percent of the wafer surface was observed at a magnification of 200, and the number of detected scratches was reduced to number/cm².)

Remaining abrasive particles: Dark-field observation under an optical microscope.
(Three percent of the wafer surface was observed at a magnification of 200, and the number of detected scratches was reduced to number/cm².)

The above-described polishing test was performed, and the tested wafer was washed by scrubbing with pure water, then spin-dried and evaluated. The test revealed that the rate of polishing the silicon dioxide film was as high as 4340 Å/min, and the rate of polishing the silicon nitride film was as considerably low as 36 Å/min. Accordingly, the selectivity is as high as 121.

In addition, no scratch was observed on either the silicon dioxide film or the silicon nitride film. Furthermore, the abrasive particles remaining on the silicon dioxide film and silicon nitride film were found to number 0.19/cm² and 0.38/cm², respectively. The results indicate that the abrasive particles were satisfactorily washed off.

### Examples 2 to 8:

The procedure of Example 1 was repeated, except that the cerium oxide concentration and EDTA·H·3(NH₄) concentration were changed, to thereby prepare slurry samples. Each slurry sample was evaluated in a manner similar to that of Example 1. The results are shown in Table 1.

### Example 9:

A poly(acrylic acid) ammonium salt was added to the abrasive composition of Example 1 to thereby prepare a slurry having a poly(acrylic acid) ammonium salt content of 0.004 mass%. The thus prepared slurry was evaluated in a manner similar to that of Example 1. The results are shown in Table 1.

### Example 10:

The procedure of Example 1 was repeated to prepare an abrasive composition in slurry form, except that β-alaninediacetic acid (β-ADA) was used as a chelating agent in place of the EDTA·H·3 (NH₄) and that ammonium water was added thereto to adjust pH of the slurry to the neighborhood of neutrality. The thus prepared slurry was evaluated in a manner similar to that of Example 1. The results are shown in Table 1.

### Example 11:

The procedure of Example 1 was repeated to prepare an abrasive composition in slurry form, except that 0.5 mass% of nitrilotriacetic acid (NTA) was used as a chelating agent in place of the EDTA·H·3(NH₄) and that ammonium water was added thereto to adjust pH of the slurry to the neighborhood of neutrality. The thus prepared slurry was evaluated in a manner similar to that of Example 1. The results are shown in Table 1.

### Example 12:

The procedure of Example 1 was repeated to prepare an abrasive composition in slurry form, except that 0.5 mass% of hydroxyethyliminodiacetic acid (HEIDA) was used as a chelating agent in place of the EDTA·H·3 (NH₄) and that ammonium water was added thereto to adjust pH of the slurry to the neighborhood of neutrality. The thus prepared slurry was evaluated in a manner similar to that of Example 1. The results are shown in Table 1.

### Example 13:

The procedure of Example 1 was repeated to prepare an abrasive composition in slurry form, except that 0.5 mass% of asparaginediacetic acid (ASDA) was used as a chelating agent in place of the EDTA·H·3(NH₄) and that ammonium water was added thereto to adjust pH of the slurry to the neighborhood of neutrality. The thus prepared slurry was evaluated in a manner similar to that of Example 1. The results are shown in Table 1.

### Example 14:

The procedure of Example 1 was repeated to prepare an abrasive composition in slurry form, except that 0.5 mass% of ethylenediaminesuccinic acid (EDDS) was used as a chelating agent in place of the EDTA·H·3(NH₄) and that ammonium water was added thereto to adjust pH of the slurry to the neighborhood of neutrality. The thus prepared slurry was evaluated in a manner similar to that of Example 1. The results are shown in Table 1.

### Comparative Example 1:

The procedure of Example 1 was repeated, except that no EDTA·H·3(NH₄) was added, to prepare a slurry. The slurry was evaluated in a manner similar to that of Example 1. The results are shown in Table 1.

When the slurry contained no chelating agent, the selectivity was low and the abrasive particles were removed insufficiently from the polished wafer surface through washing.

### Comparative Example 2:

The procedure of Example 1 was repeated, except that cerium oxide particles having an average particle size (d₅₀) of 1.9 µm and a primary particle size of 0.13 µm were used, to prepare a slurry. The slurry was evaluated in a manner similar to that of Example 1. The results are shown in Table 1.

When the cerium oxide particles had an average particle size in excess of 1.0 µm, a large number of scratches were formed on the wafer surface.

### Comparative Example 3:

The procedure of Example 1 was repeated, except that cerium oxide particles having an average particle size (d₅₀) of 0.008 µm and a primary particle size of 0.004 µm were used, to prepare a slurry. The slurry was evaluated in a manner similar to that of Example 1. The results are shown in Table 1.

When the cerium oxide had an average particle size of less than 0.01 µm, the rate of polishing the silicon oxide film was considerably low, which is not suitable for practical use.

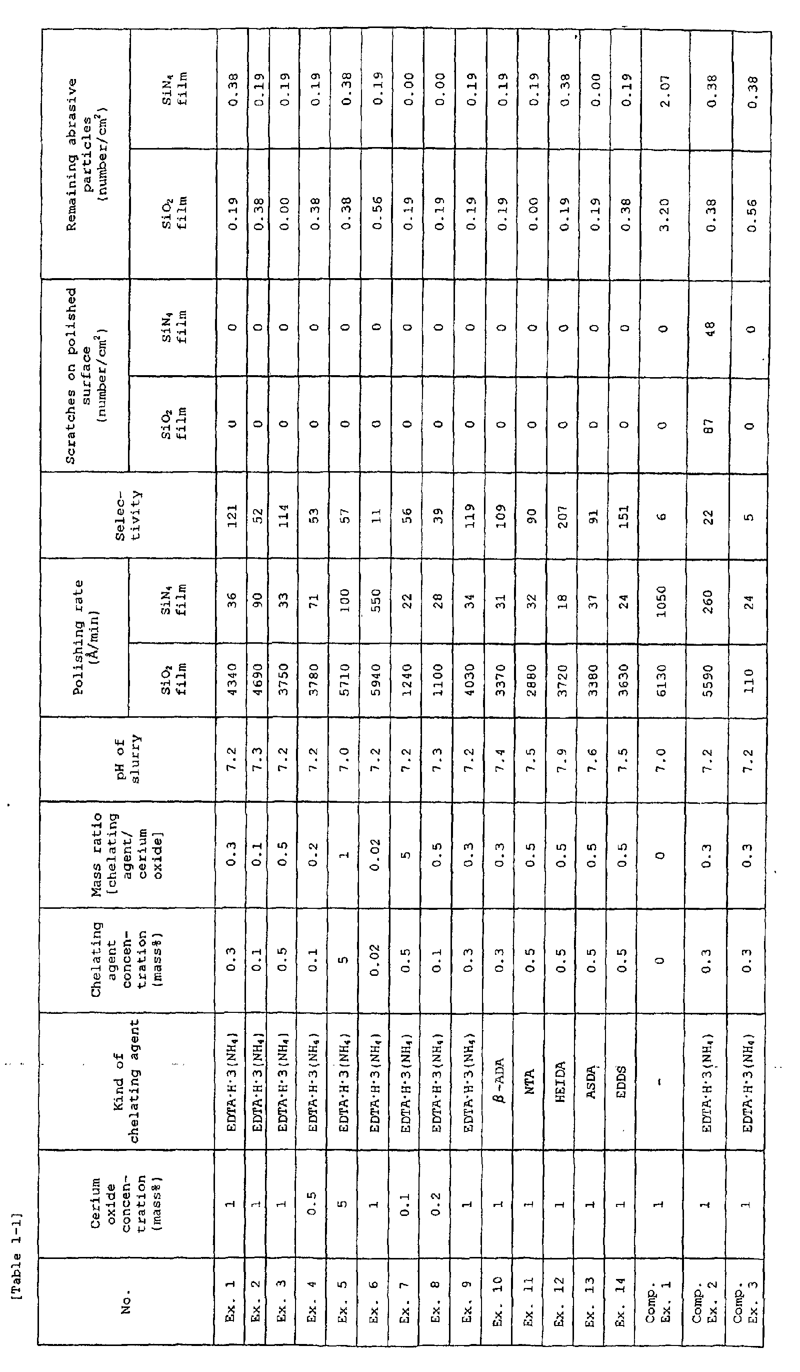

### Industrial Applicability:

The abrasive composition of the present invention can enhance the rate of polishing an oxide film that is a silicon dioxide film and the selectivity of the silicon oxide film to a silicon nitride film in terms of polishing rate, attaining highly controllable planarization polishing. In addition, the abrasive composition forms fewer scratches on the polished surface, and the abrasive particles remaining on the polished wafer can readily be removed by washing. Therefore, the abrasive composition of the present invention can preferably be used for polishing of a semiconductor device, i.e. for polishing of an oxide film, which is usually silicon dioxide, used to form a shallow trench isolation structure with a silicon nitride film used as a stopper film.

## Claims

1. An abrasive composition for polishing a semiconductor device, comprising water, microparticles of an abrasive and a chelating agent, wherein the abrasive is cerium oxide, the microparticles of cerium oxide have an average particle size of 0.01-1.0 µm, and, when silicon nitride film and silicon oxide film separately formed on a silicon substrate through CVD, are polished independently under identical conditions, a ratio of a rate of polishing the silicon nitride film to a rate of polishing the silicon oxide film is 10 or more.

2. The abrasive composition according to claim 1, wherein the abrasive further includes additional microparticles for polishing.

3. The abrasive composition according to claim 1, wherein the additional microparticles are formed of at least one species selected from the group consisting of aluminum oxide, zirconium oxide, silicon dioxide, titanium dioxide, manganese dioxide, dimanganese trioxide, chromium oxide, iron oxide, tin oxide, zinc oxide, alumina-magnesia spinel, mullite, zircon, aluminum hydroxide, calcium hydroxide, magnesium hydroxide, silicon nitride, titanium nitride, boron nitride, silicon carbide, titanium carbide and diamond.

4. The abrasive composition according to claim 1, wherein the cerium oxide has a concentration of 0.1-10 mass% and the chelating agent is added at a mass ratio of 0.01-10 based on the mass of the cerium oxide.

5. The abrasive composition according to claim 2 or claim 3, wherein the cerium oxide microparticles and additional microparticles have a total concentration of 0.1-10 mass% and the chelating agent is added at a mass ratio of 0.01-10 based on the mass of all microparticles.

6. The abrasive composition according to any one of claims 1 to 5, wherein the chelating agent is at least one compound selected from the group consisting of ethylenediaminetetraacetic acid (EDTA), cyclohexanediaminetetraacetic acid (CyDTA), nitrilotriacetic acid (NTA), hydroxyethylethylenediaminetriacetic acid (HEDTA), diethylenetriaminepentaacetic acid (DTPA), triethylenetetraminehexaacetic acid (TTHA), L-glutaminediacetic acid (GLDA), aminotri(methylenephosphonic acid), 1-hydroxy-ethylidene-1,1-diphosphonic acid, ethylenediaminetetra (methylenephosphonic acid), diethylenetriaminepenta (methylenephosphonic acid), β-alaninediacetic acid (β-ADA), α-alaninediacetic acid (α-ADA), asparaginediacetic acid (ASDA), ethylenediaminesuccinic acid (EDDS), iminodiacetic acid (IDA), hydroxyethyliminodiacetic acid (HEIDA) and 1,3-propanediaminetetraacetic acid (1,3-PDTA), or a salt thereof.

7. The abrasive composition according to claim 1, further comprising a dispersant that has a concentration of 0.08 mass% or less.

8. The abrasive composition according to claim 7, wherein the dispersant contains a poly(acrylic acid) moiety or a poly(methacrylic acid) moiety.

9. The abrasive composition according to claim 1 or claim 7, wherein it excluding the cerium oxide microparticles contains, as an impurity, at least one element selected from the group consisting of Mg, Al, K, Ca, Fe, Ni, Cu, Mn, Th and U at a concentration of 20 ppm or less.

10. The abrasive composition according to claim 1, wherein the cerium oxide microparticles have a purity of 99.9 mass% or more and contain, as an impurity, at least one element selected from the group consisting of Mg, Al, K, Ca, Fe, Ni, Cu, Mn, Th and U at a concentration of 30 ppm or less.

11. A method for producing a semiconductor device, comprising forming a silicon nitride film on a semiconductor substrate, selectively removing part of the silicon nitride film to thereby expose part of the semiconductor substrate, etching the exposed part of the semiconductor substrate with the silicon nitride film used as a mask to thereby form a trench, depositing a silicon oxide film on the silicon nitride film and on the exposed part of the semiconductor substrate to thereby completely bury the trench with the silicon oxide film, and planarization-polishing the silicon oxide film with the silicon nitride film used as a stopper to thereby selectively leave the silicon oxide remaining in the trench, wherein planarization-polishing is performed using the abrasive composition.

12. A semiconductor substrate having an element-isolated structure produced through the method according to claim 11.
